# EUROPEAN PATENT SPECIFICATION

(11) **EP 3 633 856 B1**
(45) Date of publication and mention of the grant of the patent: **02.09.2026**
(21) Application number: 18828996.1
(22) Date of filing: 03.07.2018
(51) Int. Cl.: H03L 1/00, H03L 7/093, H03L 7/087

(54) **METHOD, APPARATUS AND SYSTEM OF FREQUENCY DEVICE COMPENSATION, AND COMPUTER READABLE STORAGE MEDIUM**
VERFAHREN, VORRICHTUNG UND SYSTEM ZUR KOMPENSATION EINER FREQUENZVORRICHTUNG UND COMPUTERLESBARES SPEICHERMEDIUM
PROCÉDÉ, APPAREIL ET SYSTÈME DE COMPENSATION DE DISPOSITIF DE FRÉQUENCE, ET SUPPORT D'INFORMATIONS LISIBLE PAR ORDINATEUR

(30) Priority: 03.07.2017 CN 201710532283
(43) Date of publication of application: 08.04.2020
(73) Proprietor: ZTE Corporation, Shenzhen, Guangdong 518057 (CN)
(72) Inventor: MU, Haiming, Shenzhen Guangdong 518057 (CN)
(74) Representative: Canzler & Bergmeier Patentanwälte Partnerschaft mbB
(86) International application number: PCT/CN2018/094320
(87) International publication number: WO 2019/007337

(56) References cited:
- WO-A1-2015/039330
- CN-A- 1 859 004
- CN-A- 1 993 890
- CN-A- 101 836 132
- GB-A- 2 442 278
- US-A- 4 891 611
- US-A1- 2017 133 984
- US-B1- 8 890 591
- US-B1- 9 172 570
- US-B2- 8 461 935
- US-B2- 9 356 606
- KARIM ALLIDINA ET AL: "A temperature compensated architecture for integrated, low power, frequency domain sensors", MICROELECTRONICS (ICM), 2010 INTERNATIONAL CONFERENCE ON, IEEE, PISCATAWAY, NJ, USA, 19 December 2010 (2010-12-19), pages 164 - 167, XP031856049, ISBN: 978-1-61284-149-6
- HEIDARPOUR ROSHAN MEISAM ET AL: "A MEMS-Assisted Temperature Sensor With 20- $\mu \text{K}$ Resolution, Conversion Rate of 200 S/s, and FOM of 0.04 pJK2", IEEE JOURNAL OF SOLID-STATE CIRCUITS, IEEE, USA, vol. 52, no. 1, 1 January 2017 (2017-01-01), pages 185 - 197, XP011638637, ISSN: 0018-9200, [retrieved on 20170109], DOI: 10.1109/JSSC.2016.2621035
- HOKYU LEE ET AL: "A 0.0018 mm2 frequency-to-digital-converter-based CMOS smart temperature sensor", ANALOG INTEGRATED CIRCUITS AND SIGNAL PROCESSING, KLUWER ACADEMIC PUBLISHERS, BO, vol. 64, no. 2, 19 December 2009 (2009-12-19), pages 153 - 157, XP019812306, ISSN: 1573-1979

## Description

### TECHNICAL FIELD

The disclosure relates to the field of communications technologies, and in particular, to a method, apparatus and system of frequency device compensation, and computer readable storage medium.

### BACKGROUND

Almost all electronic equipments, communication equipments and automatic control equipments require clocks to ensure the normal operation of the system, and the clock signals of the equipments are basically from frequency devices. However, the external environment changes may affect the stability of the frequency device, resulting in an unstable clock. Some systems may also use a phase-locked loop to track an external reference clock in order to improve the accuracy of the clock. But loss of the reference source may also result in degraded clock performance. Therefore, in order to ensure that the equipment can work normally, frequency compensation needs to be carried out on the frequency device.

U.S. Patent Application Publication No. US 2017/0133984 A1 discloses an oscillator. The oscillator detects a temperature of an atmosphere where a crystal resonator for an oscillation output is placed using a temperature detector to stabilize the temperature by controlling a temperature of a heater based on a temperature detection value. The device includes a buffer amplifier interposed in a signal path of a control signal generated based on the temperature detection value, a heater disposed such that a collector and an emitter position between a power source unit and a ground and constituted of a transistor having a base connected to an output port of the buffer amplifier, and a first differential amplifier disposed to adjust a gain of the buffer amplifier to cancel voltage fluctuation of the power source unit and amplifying a difference between a voltage corresponding to the supply voltage and a preliminarily set voltage to input to a gain adjustment port of the buffer amplifier.

International Patent Application Publication No. WO 2015/039330 A1 discloses PLL and adaptive compensation method in PLL. In a method for mitigating the vibration-induced phase noise of an phase locked loop with an acceleration sensitive voltage controlled oscillator, a correction signal generated by applying a gain and a equalization to an acceleration signal provided by an acceleration sensor sensing the acceleration on the VCO, is added to the oscillator control signal for active compensation, an adaptive compensation unit dynamically adjusts the gain, the frequency response of equalization, and the sensing direction of the acceleration sensor while the phase locked loop is working to make the active compensation automatically adapt to the parameters of the voltage controlled oscillator. The acceleration signal and a filtered phase difference signal generated by a filter following the phase frequency detector of the phase locked loop are provided at the inputs of the adaptive compensation unit. In the adaptive compensation unit, a cross-correlation unit calculates the correlation coefficient and delay between the acceleration signal and the filtered phase difference signal, a gain generation unit in dependent on the correlation coefficient incrementally calculates the gain as well as the sensing direction of the acceleration sensor, and a equalization coefficient estimator in dependent on the acceleration signal, the filtered phase difference signal and the calculated delay, incrementally calculates the filter coefficients of a filter performing the equalization.

U.S. Patent No. 4,891,611 A discloses vibration compensated crystal oscillator. In order to compensate for mechanical vibration that corrupts the RF output spectrum of a crystal oscillator, three accelerometers are mounted with the oscillator and aligned on mutually perpendicular axes. The outputs of the accelerometers are digitized and applied to adaptive transversal filters comprising a digital signal processor. The crystal oscillator is placed on a vibration table and its output is compared with an external frequency reference. The tap weights of the filters are then optimized so that the vibration components of the output spectrum of the oscillator are minimized. After the tap weights of the filters are determined and fixed, the filters provide vibration compensation for the oscillator. During operation of the crystal oscillator, the outputs of the filters are summed and applied to a varactor in the oscillator to compensate the output for the effects of mechanical vibration.

UK Patent Application Publication No. GB 2442278 A discloses phase locked loop with digital compensation of environmental effects. A phase locked loop includes a phase detector and a voltage controlled oscillator (VCO). A digital control system, which includes a microprocessor and a digital to analogue converter, replaces the loop filter of prior art. The digital system receives a phase error signal from the phase detector and supplies a control voltage to the VCO. The digital control system also receives inputs from external sensors and adapts the operation of the loop to compensate for variations in environmental conditions including supply voltage, temperature, barometric pressure or radiation.

U.S. patent No. US 9,356,606 B2 provides a clock generator comprising a free-running oscillator and a tunable frequency synthesizer. The free-running oscillator has an output for providing an oscillator clock signal. The tunable frequency synthesizer is coupled to the free-running oscillator and provides a clock output signal in response to the oscillator clock signal and a frequency control signal. The frequency control signal corresponds to a measured characteristic of the free-running oscillator.

### SUMMARY

The features of the method, apparatus, system and computer-readable storage medium according to the present invention are defined in the independent claims, and the preferable features according to the present invention are defined in the dependent claims.

According to an aspect of the disclosure, there is provided a frequency device compensation method, including steps of: acquiring a clock signal output by a frequency compensation sensor to serve as a first predictive variable; acquiring a variable which is output by a predictive variable sensor and is related to frequency fluctuation to serve as a second predictive variable; and compensating the frequency device according to the first predictive variable and the second predictive variable.

According to another aspect of the disclosure, there is provided a frequency device compensation apparatus including: a frequency compensation sensor, a predictive variable sensor, and a compensation module, wherein the frequency compensation sensor is configured to output a clock signal to serve as a first predictive variable and send the first predictive variable to the compensation module; the predictive variable sensor is configured to acquire a variable related to frequency fluctuation to serve as a second predictive variable and send the first predictive variable to the compensation module; and the compensation module is configured to compensate the frequency device according to the first predictive variable and the second predictive variable.

According to still another aspect of the disclosure, there is provided a frequency device compensation system, including: a memory, a processor, and at least one application program stored in the memory and configured to be executed by the processor, wherein the application program is configured to perform the frequency device compensation method as described above.

According to yet another aspect of the disclosure, there is provided a computer-readable storage medium having stored a computer program which, when executed by a processor, implements the frequency device compensation method as described above.

### BRIEF DESCRIPTION OF THE DRAWINGS

FIG. 1 is a flowchart of a frequency device compensation method according to an embodiment of the disclosure.
FIG. 2 is a schematic diagram illustrating an operation principle of a frequency device compensation apparatus according to an embodiment of the present disclosure.
FIG. 3 is a flowchart of a frequency device compensation method according to an embodiment of the disclosure.
FIG. 4 is a flowchart of another frequency device compensation method according to an embodiment of the present disclosure.
FIG. 5 is an exemplary block diagram of a system for implementing frequency device compensation according to an embodiment of the present disclosure.
FIG. 6 is an exemplary block diagram of another system for implementing frequency device compensation according to an embodiment of the present disclosure.
FIG. 7 is an exemplary block diagram of still another system for implementing frequency device compensation according to an embodiment of the present disclosure.
FIG. 8 is a block diagram illustrating an exemplary structure of an apparatus for implementing frequency device compensation according to an embodiment of the disclosure.

Implementations, functional features, and advantages of the present disclosure will be further described below in conjunction with the detailed description and with reference to drawings.

### DETAILED DESCRIPTION

A frequency device, such as Crystal Oscillator (XO), is typically sensitive to temperature. The frequency device may experience a frequency shift over time, which is commonly referred to as aging. In some cases, the temperature data and time data are used as predictive variables to compensate frequency fluctuations in the frequency device (to compensate for aging), where the resolution and correlation of the predictive variables have a significant effect on the compensation effect.

However, the compensation is less effective mainly for two reasons: (1) when a temperature sensor is used to measure temperature data (as predictive variables), the temperature sensor has a not high but costly temperature resolution; for example, the high-precision temperature sensor commercially available on the market only has a resolution of 0.01 degree but it costs about 3 dollars; (2) the temperature data or the time data cannot compensate frequency fluctuation caused by other environmental factors; for example, the temperature data (as a predictive variable) cannot compensate frequency fluctuation such as operating power fluctuation or vibration, shock, and the like.

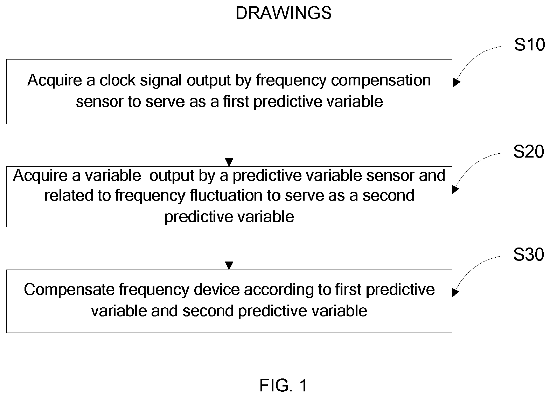

In this regard, in an embodiment of the present disclosure, there is provided a method for compensating fo frequency device. As shown in FIG. 1, the method includes steps of S10-S30.

At step S10, a clock signal output by a frequency compensation sensor is acquired as a first predictive variable.

At step S20, a variable output from a predictive variable sensor and related to a frequency fluctuation is acquired as a second predictive variable.

At step S30, the frequency device is compensated based on the first predictive variable and the second predictive variable.

Specifically, in an embodiment, the predictive variable is a variable related to the frequency fluctuation of the frequency device, and the selection of the predictive variable and the accuracy of the predictive variable may directly affect the compensation effect of the frequency device. Since the frequency device is generally sensitive to temperature and the resolution of the temperature sensor in the prior art is not high, the frequency device sensitive to temperature is used as the frequency compensation sensor in the embodiment of the present disclosure, and the clock signal output by the frequency device is used as the first predictive variable. Specifically, the frequency compensation sensor may be a clock source such as a crystal oscillator series device, an atomic clock series device, a MEMS oscillator (Micro-Electro-Mechanical System), a piezoelectric ceramic oscillator, a voltage controlled oscillator series device, and the like.

In addition to temperature-related predictive variables, the embodiment of the disclosure also consider other variables related to frequency fluctuations that cannot be compensated with temperature or time data, but that also affect the stability of the frequency device. In the embodiment of the disclosure, these variables related to frequency fluctuation but not related to temperature are taken as the second predictive variables, which mainly include voltage, current, power consumption, load fluctuation, radiation, shock, vibration, acceleration, speed, fan speed, wind speed, air pressure, humidity, and the like.

As described above, by employing a frequency sensor instead of the temperature sensor 32 and increasing the predictive variable associated with the frequency fluctuation, the accuracy and stability of the frequency compensation can be improved.

In an embodiment, the step S10 further includes steps of: acquiring a clock signal output by a frequency compensation sensor; and converting the clock signal into a digital signal through a time-to-digital converter (TDC) and using the digital signal as a first predictive variable.

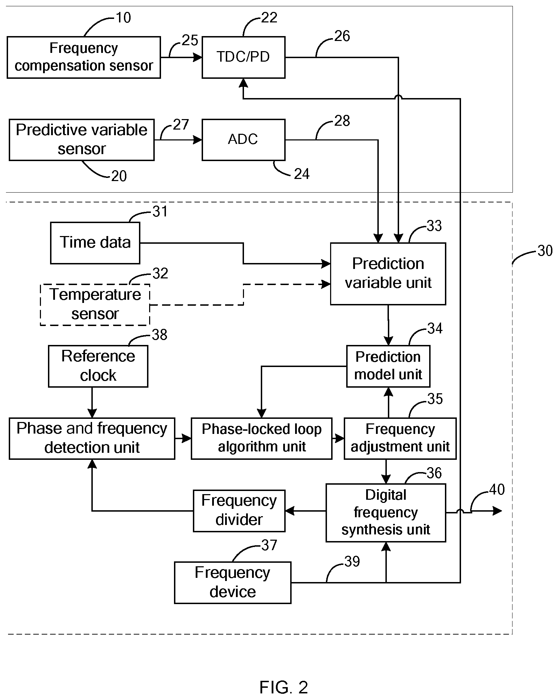

FIG. 2 is a schematic diagram illustrating an operation principle of a frequency device compensation apparatus according to an embodiment of the present disclosure. The frequency device compensation apparatus includes a frequency compensation sensor 10, a predictive variable sensor 20, and a compensation module 30. The frequency compensation sensor 10 may be any temperature sensitive frequency device that outputs a clock signal 25 to a TDC/PD 22 (Time-to-Digital Converter, Phase Detector). The TDC/PD 22 may be formed by a single device, or may be a functional block of the phase-locked loop chip, or a block implemented by a logic device. Simultaneously with receiving the clock signal 25, the TDC/PD 22 also receives as a reference clock a clock signal 39 emitted by the frequency device 37(to be compensated). Within the TDC/PD 22, the clock signal 25 is converted into a digital signal as a predictive variable, which may be a phase detection value or may be a frequency offset value and a frequency value. Subsequently, the TDC/PD 22 transmits the converted digital signal to the prediction variable unit 33 via the communication interface 26.

The predictive variable sensor 20 is a sensor that senses all other factors related to the frequency fluctuation output from frequency device 37 except for the factors sensed by the frequency compensation sensor 10, or other devices capable of performing similar functions and capable of generating digital variables. After the predictive variable sensor 20 has acquired an analog signal, the analog signal is amplified and shaped to produce a signal 27. The signal 27 is converted into a digital signal by an ADC 24 (Analog-to-Digital Converter) and then transmitted to the prediction variable unit 33 via the communication interface 28.

In most cases, the predictive variable sensor 20 and the ADC 24 are integrated and operate as a single device, for example, as a digital acceleration sensor. In practical applications, there may be more than one predictive variable sensor 20. For example, two predictive variable sensors for detecting the supply voltage and current, respectively, may be required at the same time. The communication interfaces 26 and 28 may be IIC interfaces, SPI interfaces, uart interfaces, usb interfaces, etc,. Since time data 31 is essential to aging compensation, the present disclosure retains the time data 31. The time data 31 may be generated by the frequency device 37 to be compensated or may be generated by the time base (tick) of the CPU/MCU. The frequency compensation sensor 10 needs to be placed close to the frequency device 37. In one embodiment, an improved effect can be achieved when the frequency compensation sensor 10 is placed inside the frequency device 37. In another embodiment, when frequency compensation sensor 10 and frequency device 37 are integrated and packaged as a new frequency device, the new frequency device outputs two clock frequencies. In one embodiment, an improved effect of compensation can be obtained when frequency compensation sensor 10 and frequency device 37 share a common power supply, since power supply fluctuations are reflected on both frequency devices.

In the embodiment of the disclosure, the prediction model may be trained in the presence of a reference clock. The trained prediction model may generate a set of parameters, and the parameters are used for converting the predictive variable acquired in real time into a compensation variable, wherein the compensation variable is a amount of adjustment when the frequency adjustment unit is performing compensation. It is noted that the training of the prediction model is required to be performed in the presence of the reference clock, and that only in the case of loss or severe deterioration of the reference clock, the compensation will be performed for the trained prediction model (untrained prediction model cannot be used for compensation).

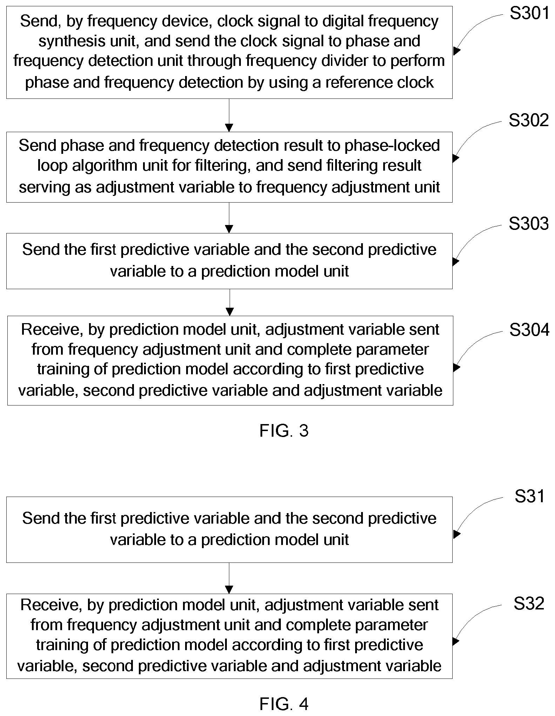

According to the embodiment of the disclosure, when, for example, the reference clock is suddenly lost, or the GPS signal as the reference clock is disturbed, so that the reference clock is lost or seriously deteriorated, the previously trained model and two types of predictive variables are required to compensate the fluctuation of the frequency device. Thus, as shown in FIG. 3, the method further comprises the steps S301-S304.

In step S301, the frequency device sends a clock signal to the digital frequency synthesis unit, and then the clock signal is transmitted to a phase frequency detection unit through a frequency divider, so as to perform phase frequency detection using the reference clock.

In step S302, a phase frequency detection result is sent to the phase-locked loop algorithm unit for filtering, and a filtering result is sent to the frequency adjustment unit as an adjustment variable.

In step S303, the first predictive variable and the second predictive variable are sent to a prediction model unit.

In step S304, the prediction model unit receives an adjustment variable sent from the frequency adjustment unit, and completes parameter training of the prediction model according to the first predictive variable, the second predictive variable, and the adjustment variable.

In this case, the step S30 further includes a step S305.

In step S305, the prediction model unit outputs a compensation variable to the phase-locked loop algorithm unit according to the currently acquired first predicted variable and second predicted variable, and then compensates the frequency device through the frequency adjustment unit.

Referring to FIG. 2, in the presence of the reference clock 38, the frequency device 37 outputs a clock signal 39 to the digital frequency synthesis unit 36, and the clock signal 39 is sent to the phase and frequency detection unit through the frequency divider to perform phase frequency detection with the reference clock 38 according to the embodiment of the present disclosure. The phase detection result is sent to the phase-locked loop algorithm unit for filtering. Finally, the filtering result is sent to the frequency adjustment unit 35. The frequency adjustment unit 35 may be a DAC circuit, a DDS (Direct Digital Synthesizer), a DCO/NCO (Digital Controlled Oscillator/Numerically Controlled Oscillator). The frequency adjustment unit 35 sends the filtering result as a variable to be adjusted to the digital frequency synthesis unit 36 to complete the frequency adjustment, and finally outputs a stable clock signal 40.

If the frequency device 37 is provided with a function of adjusting the frequency, such as, a VC-OCXO (Voltage Controlled-Oven Controlled Crystal Oscillators), it may be integrated with the digital frequency synthesis unit 36. In the process of tracking the reference clock, the prediction variable unit 33 sends the collected predictive variables to the prediction model unit 34, and the prediction model unit 34 also receives the adjustment variables sent from the frequency adjustment unit and completes parameter training of the compensation model according to the first predictive variables, the second predictive variables and the adjustment variables. After the compensation model has been trained, when the reference clock is lost, the prediction model unit 34 outputs compensation variables to the phase-locked loop algorithm unit according to the variables newly collected by the prediction variable unit, and completes the frequency compensation of the frequency device 37 through the frequency adjustment unit 35.

In the embodiment of the present disclosure, when the frequency compensation sensor and the frequency device are packaged together, the method in FIG. 3 may be used to train the predictive model, and the prediction model can be well trained before the frequency device leaves the factory. Alternatively, the method of FIG. 3 may not be used, and the phase-locked loop may be absent. In the case where no phase-locked loop is used, the method further includes the following steps S31-S32, as shown in FIG. 4.

In step S31, the first and second predictive variables are sent to a prediction model unit.

In step S32, the prediction model unit receives the adjustment variables from the frequency adjustment unit, and completes parameter training of the prediction model according to the first predictive variables, the second predictive variables, and the adjustment variables.

In this case, the step S30 further includes a step S33.

In step S33, the prediction model unit outputs a compensation variable according to the first and second predictive variables collected currently.

According to the embodiment of the disclosure, in the case where the reference clock is absent, the predictive variables need to be collected in advance, the prediction model needs to be trained, and the parameters of the prediction model need to be written into an internal memory. When using the predictive model, the parameters can be directly called out without the phase-locked loop.

In the embodiment of the present disclosure, when the reference clock is lost, the frequency adjustment unit adjusts the digital frequency synthesis unit according to the frequency adjustment amount provided by the prediction model unit and the phase-locked loop algorithm unit to output a compensated clock signal to complete the compensation. The frequency adjustment unit may also send the adjustment amount to the prediction model unit to complete training of the predictive model.

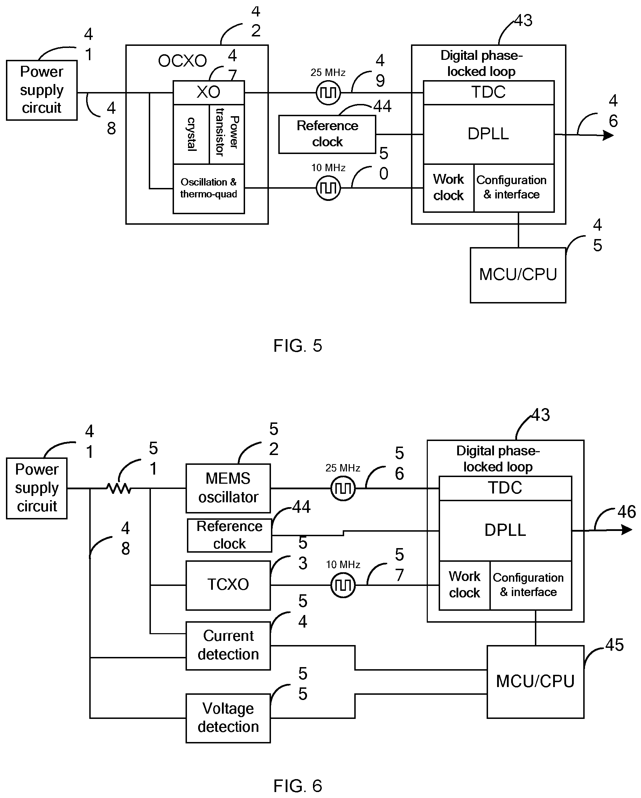

In the embodiment of the disclosure, the frequency compensation sensor and the predictive variable sensor may be formed in a variety of ways. FIG. 5 is an exemplary block diagram of a system for implementing frequency device compensation according to an embodiment of the present disclosure, the system including a power supply circuit 41, an OCXO 42, a digital phase-locked loop 43, an MCU/CPU 45 and a reference clock 44.

OCXO 42 is a compensated frequency device, into which a normal crystal oscillator XO 47 is integrated, the crystal oscillator XO 47 serving as a frequency compensation sensor. The XO 47 outputs a 25M clock signal 49 to provide a predictive variable and sends the clock signal 49 to a TDC module inside a digital phase-locked loop. A voltage signal 48 sent from the power supply circuit 41 powers the OCXO 42. Within the OCXO 42, the voltage signal 48 is supplied to a power transistor, an oscillation, and a thermo-quad circuit within the OCXO, respectively, and powers XO 47. Thus, the fluctuation on the voltage signal 48 affects both the 10MHz clock signal 50 output by the OCXO 42 and the clock signal 49 output by the XO 47. In other words, the frequency offset of the two clock signals 49 and 50 has a high correlation due to the influence of the fluctuation of the same power supply.

Within OCXO 42, XO 47 is placed close to the crystal and power transistor such that the XO 47 can accurately and quickly detect temperature variation on the crystal. This temperature variation is manifested on both the 10MHz clock signal 50 and the 25M clock signal 49. In other words, there is a high correlation of the frequency offset between them due to the temperature variation. Within the digital phase-locked loop 43, the 10MHz clock signal 50 and the 25M clock signal 49 are sent to an internal TDC module for phase detection processing. For example, a 10MHz signal and a 25MHz signal may be divided into 1Hz signals, TDC may be used to convert a phase difference between the two 1Hz signals into a time signal Δt (ns) and take the reciprocal of Δt, and then the relative frequency offset Δf(ppb) of the two clocks may be obtained. The MCU/CPU 45 reads this frequency offset Δf as a predictive variable. The time data for the prediction of aging may be generated by an operating clock of the MCU/CPU 45 or may be generated by using the 10MHz clock signal 50. When the reference clock 44 is present, the digital phase-locked loop 43 tracks the reference clock and collects frequency offset Δf and time data to train a prediction model to calculate its parameters. When the reference clock 44 is lost, the prediction model is used to predict the frequency offset of the OCXO 42, and a clock 46 can be output after compensating the frequency offset.

The frequency compensation sensor XO 47 may be replaced by a MEMS oscillator, an LC oscillator, an RC oscillator, or the like, as long as the device is sensitive to the temperature variation and can output a clock signal. The frequency compensation sensor XO 47 may also be present independently of the frequency device OCXO 42 to be compensated. For example the frequency compensation sensor XO 47 may be placed close to the OCXO 42 but in this case the compensation effect may be reduced.

FIG. 6 is an exemplary block diagram of a system for implementing frequency device compensation according to an embodiment of the present disclosure. The System comprises a power supply circuit 41, a current detection resistor 51, a MEMS oscillator 52 (Microelectromechanical System), a digital phase-locked loop 43, an MCU/CPU 45, a TCXO 34, a current detection chip 54, a voltage detection chip 55, and a reference clock 44.

In the embodiment of the disclosure, the frequency device being compensated is a TCXO 53 and the frequency compensation sensor is a MEMS oscillator 52. The TCXO 53 and MEMS oscillator 52 may be placed as close as possible and share the power supply as much as possible, thereby increasing the correlation of the frequency offsets of the output clock signals 56 and 57. The current detection resistor 51 and the current detection chip 54 may perform a current detection function. The current detection chip 54 is integrated with an ADC circuit therein to convert the magnitude of the detected current into a digital signal, and transmits the digital signal to the MCU/CPU 45 via the communication interface as a predictive variable. The voltage detection chip 55 performs a fluctuation detection on the operating voltage 48 of the TCXO 34 and sends a digital voltage signal to the MCU/CPU 45 via the communication interface as another predictive variable. The time data generation method and operation for predicting the aging of the TCXO 53 are the same as those of the previously described embodiments, and will not be described herein again.

With the voltage detection circuit, the MEMS oscillator 52 may not share a power supply with the TCXO 53. Also, the MEMS oscillator 52 serving as the frequency compensation sensor may be replaced with a general XO, LC oscillator, RC oscillator. The MEMS oscillator 52 may be implemented as a MEMS without temperature compensation, which is more sensitive to temperature, and thus the compensation effect can be further enhanced.

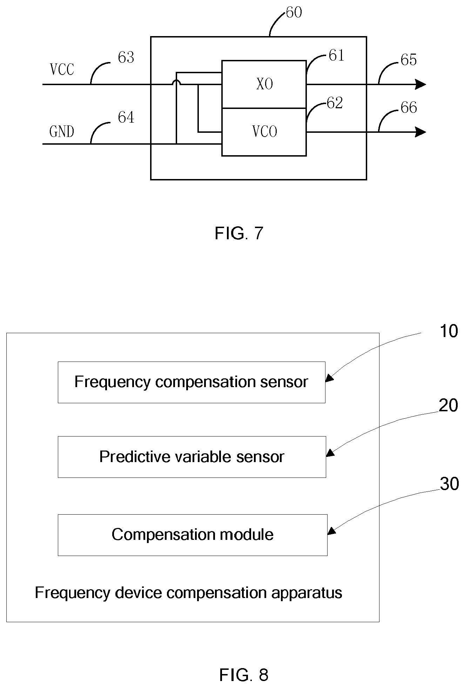

FIG. 7 is an exemplary block diagram of still another system for implementing frequency device compensation according to an embodiment of the present disclosure. The system comprises a device package 60, a frequency device XO 61 and a frequency compensation sensor VCO 62 (Voltage Controlled Oscillator). The system is input with a supply voltage VCC 63 and a ground GND 64 and outputs two clock signals which are a frequency device output clock 65 and a frequency compensation sensor output clock 66, where the clock 65 is used as a clock of the usual frequency device and the clock 66 is used as a predictive variable.

The supply voltage VCC 63 may be sent to both the XO 61 and the VCO 62, i.e., the XO 61 and the VCO 62 share the supply voltage VCC 63 as a power supply. The common power supply allows power supply fluctuations to be transferred to the clock frequencies of the clock 65 and the clock 66 output by the XO 61 and the VCO 62, respectively, thereby enhancing the compensation effect. The ground GND 64 connects the XO 61 and the VCO 62.

The frequency compensation sensor VCO 62 and the frequency device XO 61 may be placed together such that the correlation of frequency fluctuations output from the VCO 62 and XO 61 may be increased to eventually improve the compensation performance. The package 60 is a housing and base that is used for assembling the frequency device and the frequency compensation sensor together to form a new frequency device.

The frequency device XO61 is a device to be compensated, which may be a normal XO, or may be a VCXO (Voltage Controlled Crystal) Oscillator, a TCXO, an OCXO, an atomic clock series device, a MEMS oscillator, an acoustic surface device, a ceramic oscillator series device, or a VCO series device. The frequency compensation sensor VCO 62 is a frequency device for sensing a predictive variable, which may be a VCO, or may be other frequency devices, such as a MEMS oscillator typically having a lower performance than the frequency device XO61 and sensitive to temperature, an acoustic surface device, a ceramic oscillator series device, a VCXO, a TCXO, an OCXO, an atomic clock series device. In the case where the MEMS oscillator is selected as the frequency compensated sensor, an MEMS oscillator without temperature compensation may provide a better effect since it is more sensitive to temperature.

When the new frequency device incorporating the frequency compensation sensor as described above is operated together with the external phase-locked loop and the reference clock by using a compensation algorithm, the performance can be improved by a level. For example, in the case where a common XO is integrated with a VCO, the prediction model may be trained using a reference clock; after the reference clock is lost, the prediction model can be used to compensate to reach a performance as the same level as the TCXO. The cost of the common XO integrated with the VCO does not exceed 5 RMB yuan, while the TCXO costs about 5 US dollars.

In an embodiment of the disclosure, there is further provided a frequency device compensation apparatus. As shown in FIG. 8, the apparatus includes: a frequency compensation sensor 10, a predictive variable sensor 20 and a compensation module 30.

The frequency compensation sensor 10 is configured to output a clock signal as a first predictive variable and to send the first predictive variable to the compensation module.

The predictive variable sensor 20 is configured to acquire a variable related to the frequency fluctuation as a second predictive variable and to send the second predictive variable to the compensation module.

The compensation module 30 is configured to compensate the frequency device based on the first predictive variable and the second predictive variable.

In the embodiment of the disclosure, the accuracy and stability of frequency compensation can be improved by adopting a frequency sensor instead of a temperature sensor 32 and adding a predictive variable related to frequency fluctuation.

In the embodiment of the disclosure, the frequency compensation sensor further comprises a time-to-digital converter TDC, which is configured to convert the clock signal output by the frequency compensation sensor into a digital signal as the first predictive variable.

The compensation module further comprises: a digital frequency synthesis unit, a frequency divider, a phase and frequency detection unit, a prediction variable unit, a phase-locked loop algorithm unit, a frequency adjustment unit and a prediction model unit.

The digital frequency synthesis unit is configured to receive a clock signal sent from the frequency device and send the clock signal to the frequency divider.

The frequency divider is configured to send the clock signal to a phase and frequency detection unit.

The phase and frequency detection unit is configured to receive the clock signal and detect phase and frequency by using a reference clock.

The prediction variable unit is configured to receive the first predictive variable and the second predictive variable and send the first predictive variable and the second predictive variable to the prediction model unit.

The phase-locked loop algorithm unit is configured to receive a phase and frequency detection result for filtering and send a filtering result to the frequency adjustment unit.

The frequency adjustment unit is configured to send adjustment variables to the prediction model unit and receive the filtering result from the phase-locked loop algorithm unit.

The prediction model unit is configured to receive a first predictive variable and a second predictive variable sent from a prediction variable unit; and receive an adjustment variable sent from the frequency adjustment unit, and complete parameter training of a prediction model according to the first predictive variable, the second predictive variable and the adjustment variable.

The compensation module 30 is further configured to output a compensation variable to a phase-locked loop algorithm unit according to the currently acquired first predictive variable and the second predictive variable, and compensate the frequency device through the frequency adjustment unit.

The prediction variable unit is configured to receive the first predictive variable and the second predictive variable and send the first predictive variable and the second predictive variable to the prediction model unit when the frequency device is packaged with the frequency compensation sensor.

The prediction model unit is further configured to, when the frequency device and the frequency compensation sensor are packaged together, receive the first predictive variable and the second predictive variable sent from the prediction variable unit, receive the adjustment variable sent from the frequency adjustment unit, and complete the parameter training of the prediction model according to the first predictive variable, the second predictive variable and the adjustment variable.

The frequency adjustment unit is further configured to send the adjustment variable to the prediction model unit when the frequency device is packaged with the frequency compensation sensor.

The compensation module 30 is further configured to output a compensation variable according to the first predictive variable and the second predictive variable which are acquired currently when the frequency device is packaged with the frequency compensation sensor.

According to an embodiment of the disclosure, there is also provided a frequency device compensation system, which includes a memory, a processor, and at least one application program stored in the memory and configured to be executed by the processor, the application program being configured to perform the frequency device compensation method according to the embodiments as described above.

According to an embodiment of the disclosure, there is also provided a computer-readable storage medium in which a computer program is stored, which when executed by a processor, implements the frequency device compensation method according to the embodiments as described above.

It should be noted that the above-mentioned apparatus, system, and computer-readable storage medium can implement the steps and operations as described above in connection with the process embodiments, and achieve the same technical effects. For the sake of brevity, their description will be omitted herein.

Through the above description of the embodiments, those skilled in the art can clearly understand that the embodiments described herein can be implemented by software plus a necessary general hardware platform, and certainly can also be implemented by hardware. Based on such understanding, the essential part of the technical solution of the present disclosure or the part contributing to the prior art may be embodied in the form of a software product, which is stored in a storage medium (such as ROM/RAM, magnetic disk, optical disk) and includes several instructions for enabling a terminal device (which may be a mobile phone, a computer, a server, an air conditioner, or a network device, for example) to execute the frequency device compensation method according to the embodiments of the disclosure.

The exemplary embodiments of the disclosure have been explained above with reference to the drawings, and are not intended to limit the scope of the claims of the disclosure.

## Claims

1. A method of frequency device compensation for compensating a frequency device, the frequency device being a clock source device, the method comprising steps of:
acquiring (S10) a clock signal output by a frequency compensation sensor to serve as a first predictive variable, the frequency compensation sensor being another clock source device, the first predictive variable being a variable related to temperature;
acquiring (S20) a variable which is output by a predictive variable sensor and is related to frequency fluctuation of the frequency device to serve as a second predictive variable, wherein the predictive variable sensor is a sensor that senses a factor related to the frequency fluctuation output from the frequency device and different from a factor sensed by the frequency compensation sensor, and the second predictive variable is a variable related to the frequency fluctuation of the frequency device but not related to temperature; and
compensating (S30) the frequency device according to the first predictive variable and the second predictive variable,
wherein the step of acquiring a clock signal output by a frequency compensation sensor as a first predictive variable comprises steps of:
acquiring the clock signal output by the frequency compensation sensor; and
converting the clock signal into a digital signal by a time-to-digital converter TDC, and using the digital signal as the first predictive variable,
wherein the frequency device and the frequency compensation sensor are packaged, and the method further comprises steps of:
sending (S301), by the frequency device, a clock signal to a digital frequency synthesis unit, and sending the clock signal to a phase and frequency detection unit through a frequency divider so as to perform phase and frequency detection by using a reference clock;
sending (S302) a phase and frequency detection result to a phase-locked loop algorithm unit for filtering, and sending a filtering result serving as an adjustment variable to a frequency adjustment unit;
sending (S303) the first predictive variable and the second predictive variable to a prediction model unit; and
receiving (S304), by the prediction model unit, the adjustment variable sent from the frequency adjustment unit and completing parameter training of a prediction model according to the first predictive variable, the second predictive variable and the adjustment variable;
wherein the step of compensating the frequency device according to the first predictive variable and the second predictive variable comprises a step of:
outputting, by the prediction model unit, a compensation variable to the phase-locked loop algorithm unit according to the currently acquired first predictive variable and the second predictive variable, and parameters of the trained prediction model, and compensating the frequency device through the frequency adjustment unit.

2. The method of claim 1, wherein the frequency compensation sensor is a temperature sensitive frequency device.

3. A frequency device compensation apparatus for compensating a frequency device, the frequency device being a clock source device, the apparatus comprising: a frequency compensation sensor (10), a predictive variable sensor (20), and a compensation module (30), wherein
the frequency compensation sensor (10) is configured to output a clock signal to serve as a first predictive variable and send the first predictive variable to the compensation module (30), the frequency compensation sensor (10) being another clock source device, the first predictive variable being a variable related to temperature;
the predictive variable sensor (20) is configured to acquire a variable related to frequency fluctuation of the frequency device to serve as a second predictive variable and send the second predictive variable to the compensation module (30), wherein the predictive variable sensor (20) is a sensor that senses a factor related to the frequency fluctuation output from the frequency device and different from a factor sensed by the frequency compensation sensor (10), and the second predictive variable is a variable related to the frequency fluctuation of the frequency device but not related to temperature;
the compensation module (30) is configured to compensate the frequency device according to the first predictive variable and the second predictive variable; and
a time to digital converter, TDC, configured to convert the clock signal output by the frequency compensation sensor (10) to a digital signal as the first predictive variable,
wherein the frequency device and the frequency compensation sensor (10) are packaged, the compensation module (30) comprises a digital frequency synthesis unit, a frequency divider, a phase and frequency detection unit, a prediction variable unit, a phase-locked loop algorithm unit, a prediction model unit, and a frequency adjustment unit,
the digital frequency synthesis unit is configured to receive a clock signal sent from the frequency device and send the clock signal to the frequency divider;
the frequency divider is configured to send the clock signal to the phase and frequency detection unit;
the phase and frequency detection unit is configured to receive the clock signal and perform phase and frequency detection by using a reference clock;
the prediction variable unit is configured to receive the first predictive variable and the second predictive variable, and send the first predictive variable and the second predictive variable to the prediction model unit;
the phase-locked loop algorithm unit is configured to receive a phase and frequency detection result for filtering and send a filtering result as an adjustment variable to the frequency adjustment unit;
the frequency adjustment unit is configured to send the adjustment variable to the prediction model unit; and
the prediction model unit is configured to receive the first predictive variable and the second predictive variable sent from the prediction variable unit, receive the adjustment variable sent from the frequency adjustment unit, and complete parameter training of a prediction model according to the first predictive variable, the second predictive variable and the adjustment variable;
wherein, the compensation module (30) is further configured to output a compensation variable to the phase-locked loop algorithm unit according to the currently acquired first predictive variable and the second predictive variable, and parameters of the trained prediction model, and compensate the frequency device through the frequency adjustment unit.

4. The apparatus of claim 3, wherein the frequency compensation sensor (10) is a temperature sensitive frequency device.

5. A frequency device compensation system, comprising a memory, a processor, and at least one application program stored in the memory and configured to be executed by the processor, wherein the application program is configured to perform the frequency device compensation method according to any one of claims 1-2.

6. A computer-readable storage medium, wherein the computer-readable storage medium stores a computer program which, when executed by a processor, implements the frequency device compensation method according to any one of claims 1 to 2.

## Patentansprüche

1. Verfahren zur Kompensation einer Frequenz-Vorrichtung zum Kompensieren einer Frequenz-Vorrichtung, wobei die Frequenz-Vorrichtung eine Takt-Quellvorrichtung ist, wobei das Verfahren die folgenden Schritte umfasst:
Erfassen (S10) einer Takt-Signal-Ausgabe durch einen Frequenz-Kompensations-Sensor zum Bedienen als eine erste prädiktive Variable, wobei der Frequenz-Kompensations-Sensor eine andere Takt-Quellvorrichtung ist, wobei die erste prädiktive Variable eine Variable ist, die mit einer Temperatur in Beziehung steht;
Erfassen (S20) einer Variable, die durch einen prädiktiven Variablen-Sensor ausgegeben wird und mit einer Frequenz-Fluktuation der Frequenz-Vorrichtung in Beziehung steht, zum Bedienen als eine zweite prädiktive Variable, wobei der prädiktive Variablen-Sensor ein Sensor ist, der einen Faktor erfasst, der mit der Frequenz-Fluktuation in Beziehung steht, die von der Frequenz-Vorrichtung ausgegeben wird, und sich von einem Faktor unterscheidet, der durch den Frequenz-Kompensations-Sensor erfasst wird, und die zweite prädiktive Variable eine Variable ist, die mit der Frequenz-Fluktuation der Frequenz-Vorrichtung in Beziehung steht, aber nicht mit einer Temperatur in Beziehung steht; und
Kompensieren (S30) der Frequenz-Vorrichtung gemäß der ersten prädiktiven Variable und der zweiten prädiktiven Variable,
wobei der Schritt des Erfassens einer Takt-Signal-Ausgabe durch einen Frequenz-Kompensations-Sensor als eine erste prädiktive Variable die folgenden Schritte umfasst:
Erfassen der Takt-Signal-Ausgabe durch den Frequenz-Kompensations-Sensor; und
Umwandeln des Takt-Signals in ein digitales Signal durch einen Zeit-Digital-Wandler, TDC, und Verwenden des digitalen Signals als die erste prädiktive Variable,
wobei
die Frequenz-Vorrichtung und der Frequenz-Kompensations-Sensor gepackt sind und das Verfahren ferner die folgenden Schritte umfasst:
Senden (S301), durch die Frequenz-Vorrichtung, eines Takt-Signals an eine digitale Frequenz-Synthese-Einheit und Senden des Takt-Signals an eine Phase- und Frequenz-Detektionseinheit durch einen Frequenz-Teiler, um eine Phase- und Frequenz-Detektion durch Verwenden eines Referenz-Takts durchzuführen;
Senden (S302) eines Phase- und Frequenz-Detektionsergebnisses an eine Phasenregelkreis-Algorithmus-Einheit zum Filtern und Senden eines Filterergebnisses zum Bedienen als eine Anpassung-Variable an eine Frequenz-Anpassung-Einheit;
Senden (S303) der ersten prädiktiven Variable und der zweiten prädiktiven Variable an eine Vorhersage-Modell-Einheit; und
Empfangen (S304), durch die Vorhersage-Modell-Einheit, der Anpassung-Variable gesendet von der Frequenz-Anpassung-Einheit und Vervollständigen eines Parameter-Trainierens eines Vorhersage-Modells gemäß der ersten prädiktiven Variable, der zweiten prädiktiven Variable und der Anpassung-Variable;
wobei der Schritt des Kompensierens der Frequenz-Vorrichtung gemäß der ersten prädiktiven Variable und der zweiten prädiktiven Variable einen folgenden Schritt umfasst:
Ausgeben, durch die Vorhersage-Modell-Einheit, einer Kompensations-Variable an die Phasenregelkreis-Algorithmus-Einheit gemäß der aktuell erfassten ersten prädiktiven Variable und der zweiten prädiktiven Variable und Parameter des trainierten Vorhersage-Modells und Kompensieren der Frequenz-Vorrichtung durch die Frequenz-Anpassung-Einheit.

2. Verfahren nach Anspruch 1, wobei der Frequenz-Kompensations-Sensor eine Temperatur-empfindliche Frequenz-Vorrichtung ist.

3. Vorrichtung zur Kompensation einer Frequenz-Vorrichtung zum Kompensieren einer Frequenz-Vorrichtung, wobei die Frequenz-Vorrichtung eine Takt-Quellvorrichtung ist, wobei die Vorrichtung umfasst: einen Frequenz-Kompensations-Sensor (10), einen prädiktiver Variablen-Sensor (20) und ein Kompensations-Modul (30), wobei
der Frequenz-Kompensations-Sensor (10) konfiguriert ist zum Ausgeben eines Takt-Signals zum Bedienen als eine erste prädiktive Variable und zum Senden der ersten prädiktiven Variable an das Kompensations-Modul (30), wobei der Frequenz-Kompensations-Sensor (10) eine andere Takt-Quellvorrichtung ist, wobei die erste prädiktive Variable eine Variable ist, die mit einer Temperatur in Beziehung steht;
der prädiktive Variablen-Sensor (20) konfiguriert ist zum Erfassen einer Variable, die mit einer Frequenz-Fluktuation der Frequenz-Vorrichtung in Beziehung steht, zum Bedienen als eine zweite prädiktive Variable und zum Senden der zweiten prädiktiven Variable an das Kompensations-Modul (30), wobei der prädiktive Variablen-Sensor (20) ein Sensor ist, der einen Faktor erfasst, der mit der Frequenz-Fluktuation in Beziehung steht, die von der Frequenz-Vorrichtung ausgegeben wird, und sich von einem Faktor unterscheidet, der durch den Frequenz-Kompensations-Sensor (10) erfasst wird, und die zweite prädiktive Variable eine Variable ist, die mit der Frequenz-Fluktuation der Frequenz-Vorrichtung in Beziehung steht, aber nicht mit einer Temperatur in Beziehung steht;
das Kompensationsmodul (30) konfiguriert ist zum Kompensieren der Frequenz-Vorrichtung gemäß der ersten prädiktiven Variable und der zweiten prädiktiven Variable; und
einen Zeit-Digital-Wandler, TDC, der konfiguriert ist zum Umwandeln der Takt-Signal-Ausgabe durch den Frequenz-Kompensations-Sensor (10) in ein digitales Signal als die erste prädiktive Variable,
wobei die Frequenz-Vorrichtung und der Frequenz-Kompensations-Sensor (10) gepackt sind, das Kompensationsmodul (30) eine digitale Frequenz-Synthese-Einheit, einen Frequenz-Teiler, eine Phase- und Frequenz-Detektionseinheit, eine Vorhersage-Variable-Einheit, eine Phasenregelkreis-Algorithmus-Einheit, eine Vorhersage-Modell-Einheit und eine Frequenz-Anpassung-Einheit umfasst,
die digitale Frequenz-Synthese-Einheit konfiguriert ist zum Empfangen eines Takt-Signals, das von der Frequenz-Vorrichtung gesendet wird, und zum Senden des Takt-Signals an den Frequenz-Teiler;
der Frequenz-Teiler konfiguriert ist zum Senden des Takt-Signals an die Phase- und Frequenz-Detektionseinheit;
die Phase- und Frequenz-Detektionseinheit konfiguriert ist zum Empfangen des Takt-Signals und zum Durchführen einer Phase- und Frequenz-Detektion durch Verwenden eines Referenz-Takts;
die Vorhersage-Variable-Einheit konfiguriert ist zum Empfangen der ersten prädiktiven Variable und der zweiten prädiktiven Variable und zum Senden der ersten prädiktiven Variable und der zweiten prädiktiven Variable an die Vorhersage-Modell-Einheit;
die Phasenregelkreis-Algorithmus-Einheit konfiguriert ist zum Empfangen eines Phase- und Frequenz-Detektionsergebnisses zum Filtern und zum Senden eines Filterergebnisses als eine Anpassung-Variable an die Frequenz-Anpassung-Einheit;
die Frequenz-Anpassung-Einheit konfiguriert ist zum Senden der Anpassung-Variable an die Vorhersage-Modell-Einheit; und
die Vorhersage-Modell-Einheit konfiguriert ist zum Empfangen der ersten prädiktiven Variable und der zweiten prädiktiven Variable gesendet von der Vorhersage-Variable-Einheit, zum Empfangen der Anpassung-Variable gesendet von der Frequenz-Anpassung-Einheit und zum Vervollständigen eines Parameter-Trainierens eines Vorhersage-Modells gemäß der ersten prädiktiven Variable, der zweiten prädiktiven Variable und der Anpassung-Variable;
wobei das Kompensations-Modul (30) ferner konfiguriert ist zum Ausgeben einer Kompensations-Variable an die Phasenregelkreis-Algorithmus-Einheit gemäß der aktuell erfassten ersten prädiktiven Variable und der zweiten prädiktiven Variable und Parameter des trainierten Vorhersage-Modells und zum Kompensieren der Frequenz-Vorrichtung durch die Frequenz-Anpassung-Einheit.

4. Vorrichtung nach Anspruch 3, wobei der Frequenz-Kompensations-Sensor (10) eine Temperatur-empfindliche Frequenz-Vorrichtung ist.

5. Frequenz-Vorrichtung-Kompensations-System, umfassend einen Speicher, einen Prozessor und mindestens ein Anwendungsprogramm, das in dem Speicher gespeichert ist und konfiguriert ist zum Ausführen durch den Prozessor, wobei das Anwendungsprogramm konfiguriert ist zum Durchführen des Frequenz-Vorrichtung-Kompensations-Verfahrens gemäß einem der Ansprüche 1-2.

6. Computerlesbares Speichermedium, wobei das computerlesbare Speichermedium ein Computerprogramm speichert, das, wenn es durch einen Prozessor ausgeführt wird, das Frequenz-Vorrichtung-KompensationsVerfahren gemäß einem der Ansprüche 1 bis 2 implementiert.

## Revendications

1. Procédé de compensation de dispositif de fréquence pour compenser un dispositif de fréquence, le dispositif de fréquence étant un dispositif de source d'horloge, le procédé comprenant les étapes consistant à :
acquérir (S10) un signal d'horloge délivré par un capteur de compensation de fréquence pour servir de première variable prédictive, le capteur de compensation de fréquence étant un autre dispositif de source d'horloge, la première variable prédictive étant une variable liée à la température ;
acquérir (S20) une variable qui est délivrée par un capteur de variable prédictive et est liée à une fluctuation de fréquence du dispositif de fréquence pour servir de seconde variable prédictive, dans lequel le capteur de variable prédictive est un capteur qui détecte un facteur lié à la fluctuation de fréquence délivrée par le dispositif de fréquence et différent d'un facteur détecté par le capteur de compensation de fréquence, et la seconde variable prédictive est une variable liée à la fluctuation de fréquence du dispositif de fréquence mais non liée à la température ; et
compenser (S30) le dispositif de fréquence selon la première variable prédictive et la seconde variable prédictive,
dans lequel l'étape consistant à acquérir un signal d'horloge délivré par un capteur de compensation de fréquence en tant que première variable prédictive comprend les étapes consistant à :
acquérir le signal d'horloge délivré par le capteur de compensation de fréquence ; et
convertir le signal d'horloge en un signal numérique par un convertisseur temps-numérique, TDC, et utiliser le signal numérique en tant que première variable prédictive,
dans lequel
le dispositif de fréquence et le capteur de compensation de fréquence sont encapsulés, et le procédé comprend en outre les étapes consistant à :
envoyer (S301), par le dispositif de fréquence, un signal d'horloge à une unité de synthèse de fréquence numérique, et envoyer le signal d'horloge à une unité de détection de phase et de fréquence par l'intermédiaire d'un diviseur de fréquence de manière à réaliser une détection de phase et de fréquence en utilisant une horloge de référence ;
envoyer (S302) un résultat de détection de phase et de fréquence à une unité d'algorithme de boucle à verrouillage de phase pour filtrer, et envoyer un résultat de filtrage servant de variable d'ajustement à une unité d'ajustement de fréquence ;
envoyer (S303) la première variable prédictive et la seconde variable prédictive à une unité de modèle de prédiction ; et
recevoir (S304), par l'unité de modèle de prédiction, la variable d'ajustement envoyée par l'unité d'ajustement de fréquence et compléter un entraînement de paramètre d'un modèle de prédiction selon la première variable prédictive, la seconde variable prédictive et la variable d'ajustement ;
dans lequel l'étape consistant à compenser le dispositif de fréquence selon la première variable prédictive et la seconde variable prédictive comprend une étape consistant à :
délivrer, par l'unité de modèle de prédiction, une variable de compensation à l'unité d'algorithme de boucle à verrouillage de phase selon la première variable prédictive et la seconde variable prédictive actuellement acquises, et des paramètres du modèle de prédiction entraîné, et compenser le dispositif de fréquence par l'intermédiaire de l'unité d'ajustement de fréquence.

2. Procédé selon la revendication 1, dans lequel le capteur de compensation de fréquence est un dispositif de fréquence sensible à la température.

3. Appareil de compensation de dispositif de fréquence pour compenser un dispositif de fréquence, le dispositif de fréquence étant un dispositif de source d'horloge, l'appareil comprenant : un capteur de compensation de fréquence (10), un capteur de variable prédictive (20), et un module de compensation (30), dans lequel
le capteur de compensation de fréquence (10) est configuré pour délivrer un signal d'horloge pour servir de première variable prédictive et envoyer la première variable prédictive au module de compensation (30), le capteur de compensation de fréquence (10) étant un autre dispositif de source d'horloge, la première variable prédictive étant une variable liée à la température ;
le capteur de variable prédictive (20) est configuré pour acquérir une variable liée à une fluctuation de fréquence du dispositif de fréquence pour servir de seconde variable prédictive et envoyer la seconde variable prédictive au module de compensation (30), dans lequel le capteur de variable prédictive (20) est un capteur qui détecte un facteur lié à la fluctuation de fréquence délivrée par le dispositif de fréquence et différent d'un facteur détecté par le capteur de compensation de fréquence (10), et la seconde variable prédictive est une variable liée à la fluctuation de fréquence du dispositif de fréquence mais non liée à la température ;
le module de compensation (30) est configuré pour compenser le dispositif de fréquence selon la première variable prédictive et la seconde variable prédictive ; et
un convertisseur temps-numérique, TDC, configuré pour convertir le signal d'horloge délivré par le capteur de compensation de fréquence (10) en un signal numérique en tant que première variable prédictive,
dans lequel le dispositif de fréquence et le capteur de compensation de fréquence (10) sont encapsulés, le module de compensation (30) comprend une unité de synthèse de fréquence numérique, un diviseur de fréquence, une unité de détection de phase et de fréquence, une unité de variable de prédiction, une unité d'algorithme de boucle à verrouillage de phase, une unité de modèle de prédiction, et une unité d'ajustement de fréquence,
l'unité de synthèse de fréquence numérique est configurée pour recevoir un signal d'horloge envoyé par le dispositif de fréquence et envoyer le signal d'horloge au diviseur de fréquence ;
le diviseur de fréquence est configuré pour envoyer le signal d'horloge à l'unité de détection de phase et de fréquence ;
l'unité de détection de phase et de fréquence est configurée pour recevoir le signal d'horloge et réaliser une détection de phase et de fréquence en utilisant une horloge de référence ;
l'unité de variable de prédiction est configurée pour recevoir la première variable prédictive et la seconde variable prédictive, et envoyer la première variable prédictive et la seconde variable prédictive à l'unité de modèle de prédiction ;
l'unité d'algorithme de boucle à verrouillage de phase est configurée pour recevoir un résultat de détection de phase et de fréquence pour filtrer et envoyer un résultat de filtrage en tant que variable d'ajustement à l'unité d'ajustement de fréquence ;
l'unité d'ajustement de fréquence est configurée pour envoyer la variable d'ajustement à l'unité de modèle de prédiction ; et
l'unité de modèle de prédiction est configurée pour recevoir la première variable prédictive et la seconde variable prédictive envoyées par l'unité de variable de prédiction, recevoir la variable d'ajustement envoyée par l'unité d'ajustement de fréquence, et compléter un entraînement de paramètre d'un modèle de prédiction selon la première variable prédictive, la seconde variable prédictive et la variable d'ajustement ;
dans lequel, le module de compensation (30) est en outre configuré pour délivrer une variable de compensation à l'unité d'algorithme de boucle à verrouillage de phase selon la première variable prédictive et la seconde variable prédictive actuellement acquises, et des paramètres du modèle de prédiction entraîné, et compenser le dispositif de fréquence par l'intermédiaire de l'unité d'ajustement de fréquence.

4. Appareil selon la revendication 3, dans lequel le capteur de compensation de fréquence (10) est un dispositif de fréquence sensible à la température.

5. Système de compensation de dispositif de fréquence, comprenant une mémoire, un processeur, et au moins un programme d'application stocké dans la mémoire et configuré pour être exécuté par le processeur, dans lequel le programme d'application est configuré pour réaliser le procédé de compensation de dispositif de fréquence selon l'une quelconque des revendications 1 à 2.

6. Moyen de stockage lisible par ordinateur, dans lequel le moyen de stockage lisible par ordinateur stocke un programme informatique qui, lorsqu'il est exécuté par un processeur, met en œuvre le procédé de compensation de dispositif de fréquence selon l'une quelconque des revendications 1 à 2.
